# EUROPEAN PATENT APPLICATION

(11) **EP 1 026 284 A1**
(43) Date of publication of application: **09.08.2000**
(21) Application number: 99929829.2
(22) Date of filing: 14.07.1999
(51) Int. Cl.: C23C 14/34, C23C 14/16, H01L 21/283

(54) **SPUTTERING TARGET AND PART FOR THIN FILM-FORMING APPARATUS**

(30) Priority: 14.07.1998 JP 19856598
(71) Applicant: JAPAN ENERGY CORPORATION, Tokyo 105-0001 (JP)
(72) Inventor: Takahashi, Kazunari, Isohara Fact. Nikko Corp. Lt, Kitaibaraki-shi, Ibaraki-ken 319-1535 (JP); Miyashita, Hirohito, Isohara Fact. Nikko Corp., Kitaibaraki-shi, Ibaraki-ken 319-1535 (JP)
(74) Representative: Meddle, Alan Leonard
(86) International application number: JP9903796
(87) International publication number: WO0004203

(57) **Abstract**

The present invention provides a sputtering target and a component part of thin film forming equipment including a high-purity copper alloy, which have a small wiring resistance, excel in resistance to electro-migration and oxidation, and are able to form a wiring film having excellent uniformity of film composition and film thickness. Such a sputtering target and component part of thin film forming equipment are manufactured from a high-purity copper alloy, wherein the content of each of Na and K is 0.5 ppm or less, the content of each of Fe, Ni, Cr, Al, and Ca is 2 ppm or less, the content of oxygen is 5 ppm or less, the content of each of U and Th is 1 ppb or less, the content of Mg is 0.02 to 4wt%, and the content of copper is 99.99wt% or more in the remaining copper other than the gaseous components and Mg.

## Description

### Technical Field

The present invention relates to a sputtering target and a component part of thin film forming equipment comprising a high-purity copper alloy for the manufacture of a semiconductor thin film wiring material for an LSI or the like. More specifically, the present invention relates to a sputtering target which is capable of forming a wiring film that excels in resistance to electro-migration and oxidation, and in the uniformity of the film thickness and a component part of thin film forming equipment having the same composition as the target.

### Background Art

Heretofore, Al or Al alloys have generally been used as wiring materials for semiconductor integrated circuits or the like. However, with the size reduction of elements and wiring due to increase in the density of integrated circuits, the problems of increase in wiring resistance and electro-migration or the like have arisen. In order to solve these problems, studies have been carried out on wiring utilizing copper which has a low resistance and excels in resistance to electro-migration as a material substituting Al, and wiring made of pure copper has practically been utilized. Also, concurrent with increase in the number of layers, sputtering equipment of which component part of the film forming chamber is subjected to erosion has practically been used in a special sputtering method which excels in step coverage for forming films on which contact holes or the like having a large aspect ratio are formed.

However, due to increase in complexity of the process caused by further size reduction and increase in the number of layers of wiring, even copper wiring has not been able to meet the requirements. Under such a situation, copper alloys having better resistance to electro-migration and to oxidation during the process are attracting attention as wiring materials. Also, as the component part subjected to erosion used in the above-described sputtering equipment, pure copper of the purity of 5 nines or more has been used even if wiring is made of a copper alloy. However, the film thus formed has not necessarily had satisfactory uniformity of film composition and film thickness.

Although copper alloys have been studied, if an element is added for improving resistance to electro-migration and oxidation, wiring resistance increases, while if wiring resistance is lowered below a certain value, resistance to electro-migration and oxidation cannot be obtained. Therefore, the alloy system and the composition thereof meeting both requirements by solving such an antinomic problem have not been obtained.

The present invention provides a sputtering target and a component part of thin film forming equipment comprising a high-purity copper alloy, which have a small wiring resistance, excel in resistance to electro-migration and oxidation, and are able to form a wiring film having excellent uniformity of film composition and film thickness.

### Disclosure of the Invention

In order to solve the above-described problems, the present inventors conducted repeated experiments, and found that a film which has a low wiring resistance and excels in resistance to electro-migration and oxidation could be obtained by selecting Mg as the element to be added, determining the composition within a certain range, and specifying the quantity of impurities in remaining copper. It was also found that the control of crystal grain diameters of the target below a certain value, and the reduction of variation of the grain diameters were extremely effective for realizing the film which excelled in the uniformity of film composition and film thickness; and that the uniformity of film composition and film thickness was further improved by changing the material for the component parts subjected to erosion from pure copper to the copper-Mg alloy same as in the target.

That is, according to a first aspect of the present invention, there is provided a sputtering target comprising a high-purity copper alloy, wherein the content of each of Na and K is 0.5 wt (by weight) ppm (hereinafter: ppm) or less, the content of each of Fe, Ni, Cr, Al, and Ca is 2 ppm or less, the content of oxygen is 5 ppm or less, the content of each of U and Th is 1 wt ppb (hereinafter: ppb) or less, the content of Mg is 0.02 to 4wt% (by weight %), and the content of copper is 99.99wt% or more in the remaining copper other than the gaseous components and Mg.

According to a second of the present invention, there is provided a sputtering target comprising a high-purity copper alloy, wherein the content of each of Na and K is 0.1 ppm or less, the content of each of Fe, Ni, Cr, Al, and Ca is 1 ppm or less, the content of oxygen is 5 ppm or less, the content of each of U and Th is 1 ppb or less, the content of Mg is 0.02 to 4wt%, and the content of copper is 99.995wt% or more in the remaining copper other than the gaseous components and Mg.

According to a third aspect of the present invention, there is provided the sputtering target comprising a high-purity copper alloy according to the first or second aspect, wherein the crystal grain diameter of the target materials is 200 µm or less, and the variation of the average grain diameter throughout the target materials is ±20% or less.

According to a fourth aspect of the present invention, there is provided the sputtering target comprising a high-purity copper alloy according to the first or second aspect, wherein the crystal grain diameter of the target materials is 50 µm or less, and the variation of the average grain diameter throughout the target materials is ±20% or less.

According to a fifth aspect of the present invention, there is provided a component part of thin film forming equipment used during the sputtering of the target according to any of the first to fourth aspects, wherein the content of each of Na and K is 0.5 ppm or less, the content of each of Fe, Ni, Cr, Al, and Ca is 2 ppm or less, the content of oxygen is 5 ppm or less, the content of each of U and Th is 1 ppb or less, the content of Mg is 0.02 to 4wt%, and the content of copper is 99.99wt% or more in the remaining copper other than the gaseous components and Mg; and the component part is subjected to erosion during sputtering.

According to a sixth aspect of the present invention, there is provided a component part of thin film forming equipment used during the sputtering of the target according to any of the first to fourth aspects, wherein the content of each of Na and K is 0.1 ppm or less, the content of each of Fe, Ni, Cr, Al, and Ca is 1 ppm or less, the content of oxygen is 1 ppm or less, the content of each of U and Th is 1 ppb or less, the content of Mg is 0.02 to 4wt%, and the content of copper is 99.99wt% or more in the remaining copper other than the gaseous components and Mg; and the component part is subjected to erosion during sputtering.

### Detailed Description of the Preferred Embodiments

The present invention will be described below in detail.

In order to guarantee the reliability of operation of semiconductor elements formed by sputtering, it is required to eliminate impurities which are harmful for the semiconductor elements as much as possible. Particularly harmful impurities include:
(1) Alkaline metal elements such as Na and K,
(2) Radioactive elements such as U and Th, and
(3) Transition metal elements such as Fe, Ni, and Cr.

Since alkaline metal elements such as Na and K diffuse easily, and migrate within the insulating film easily to cause the properties of the MOS-LSI interface to degrade, the content of each of them should be 0.5 ppm or less, preferably 0.1 ppm or less.

Since radioactive elements such as U and Th radiate α-rays cause the soft error of semiconductor elements, the content of each of these elements should be strictly limited to 1 ppb or less.

Transition metal elements such as Fe, Ni, and Cr may cause the trouble of interfacial junctions. Therefore, the content of each of them should be 2 ppm or less, preferably 1 ppm or less.

In addition to such elements harmful to semiconductor elements, other impurities must also be minimized. Therefore, the content of each of light metal elements such as Al and Ca, as well as heavy metal elements should be 2 ppm or less, preferably 1 ppm or less.

In addition, since the presence of oxygen is not preferable because it elevates the electrical resistance of the formed film or the like, and affects the surface morphology of the film, the content of oxygen should be 5 ppm or less.

Furthermore, since other impurity components may lower electrical resistance, it is preferred to minimize them as much as possible, and the content of each of them should be 2 ppm or less, preferably 0.5 ppm or less. The overall purity of copper, other than gaseous components and Mg, should be 99.99wt% or more, preferably 99.995wt% or more.

The content of Mg, which is an additive component, less than 0.02wt% has no effect for the improvement of resistance to electro-migration and oxidation, while the content exceeding 4wt% is not preferred because of the significant increase of wiring resistance. Also, the content of Mg exceeding 4wt% is not preferred because the segregation of magnesium cannot be ignored, and the variation of sheet resistance increases.

Furthermore, in order to realize the uniformity of composition and thickness of the film formed by sputtering, it is effective to reduce the crystal grain diameter of the target, and to minimize the variation of the crystal grain diameter. The average grain diameter in the sputtered surface, and the variation of the average grain diameter across the surface affect the uniformity of composition and thickness of the film.

If the average grain diameter exceeds 200 µm, it is difficult to lower the mean dispersion of the sheet resistance in an 8-inch wafer to 2.0 or less. Moreover, if the variation across the surface exceeds 20%, the mean dispersion of the sheet resistance undesirably becomes 2.0 or more. More preferably, if the average grain diameter is 50 µm or less, and the variation across the surface to 20% or less, the mean dispersion of the sheet resistance in an 8-inch wafer can be about 1.0. The average grain diameter used herein is the value obtained by the cutting method in accordance with JIS H 0501. The variation used herein is the variation of average grain diameters over a large area, such as at the center, at the middle point of the radius, and at the circumference of the sputtering surface of an circular target about 300 mm in diameter, and also the variation of average grain diameters in the thickness direction of the target, such as at the top, at the mid-point of the thickness, and the bottom. The variation of the sheet resistance depends on the uniformity of both film composition and film thickness.

In addition, the mean dispersion of the sheet resistance in an 8-inch wafer can further be lowered to about 0.7 by changing the material of parts subjected to erosion from pure copper to a copper-Mg alloy same as the target.

### [Examples]

The present invention will be described in detail below referring to examples; however, the present invention is by no means limited to these examples.

### (Example 1) Target 1

A high-purity copper alloy ingot (157 mm in diameter, 60 mm in thickness) having an Mg content of 0.03wt%, prepared by the electrolytic purification of electrolytic copper in a nitric acid acidic bath in which the anode and the cathode are separated by a diaphragm, the addition of Mg, and vacuum melting, was heated to 400°C and hot-forged to 190 mm in diameter and 40 mm in thickness. This was further heated to 400°C, and rolled to 265 mm in diameter and 20 mm in thickness. Thereafter, this work piece was cold-rolled to 360 mm in diameter and 10 mm in thickness, heat-treated at 500°C for one hour, and latched into a disc having a diameter of 13 inches and a thickness of 7 mm. The backing plate was made of an Al alloy having a diameter of 13 inches and a thickness of 15 mm. After the target and the backing plate were degreased and washed by acetone using ultrasonic waves, they were laminated by solid phase diffusion bonding in a vacuum of 5 × 10⁻³ torr at a bonding temperature of 300°C under a pressure of 10 kg/mm². After bonding, the laminated pair was machined into a diffusion-joined target with a backing plate, having a target dimensions of 12.98 inches in diameter and 6.35 mm in thickness.

### (Example 2) Target 2

A target was fabricated in the same conditions as in Example 1 except that the Mg content was 0.8wt%.

### (Example 3) Target 3

A target was fabricated in the same conditions as in Example 1 except that the Mg content was 1.5wt%.

### (Example 4) Target 4

A target was fabricated in the same conditions as in Example 1 except that the Mg content was 3.7wt%.

### (Example 5) Target 5

A target was fabricated in the same conditions as in Example 1 except that the Mg content was 0.8wt%, and the heat-treatment temperature was 600°C.

### (Example 6) Target 6

A target was fabricated in the same conditions as in Example 1 except that the Mg content was 0.8wt%. A high-purity copper alloy ingot of the same composition (157 mm in diameter and 60 mm in thickness) was heated to 400°C, and was hot-forged to 480 mm in length, 60 mm in width, and 40 mm in thickness. From this a material for component parts was cut, and machined into a pin and a cap for covering the pin. Thereafter, the remaining material was cold-rolled to 1400 mm in length, 60 mm in width, and 10 mm in thickness, heat-treated at 500°C for one hour, and machined into a ring.

### [Comparative Examples]

### (Comparative Example 1) Target 7

A target was fabricated in the same conditions as in Example 1 except that no Mg was added.

### (Comparative Example 2) Target 8

A target was fabricated in the same conditions as in Example 1 except that the Mg content was 4.5wt%.

### (Comparative Example 3) Target 9

A diffusion-joined target was fabricated in the same process as in Example 1 using a copper alloy ingot of an Mg content of 0.8wt% prepared by vacuum induction melting of electrolytic copper having a purity of 3N5 together with Mg.

### (Comparative Example 4) Target 10

A target was fabricated in the same conditions as in Comparative Example 3 except that the heat-treatment temperature was 700°C.

### (Comparative Example 5) Target 11

A target was fabricated in the same conditions as in Comparative Example 1 except that the heat-treatment temperature was 300°C.

The Mg content and impurity contents of targets thus fabricated are shown in Table 1.

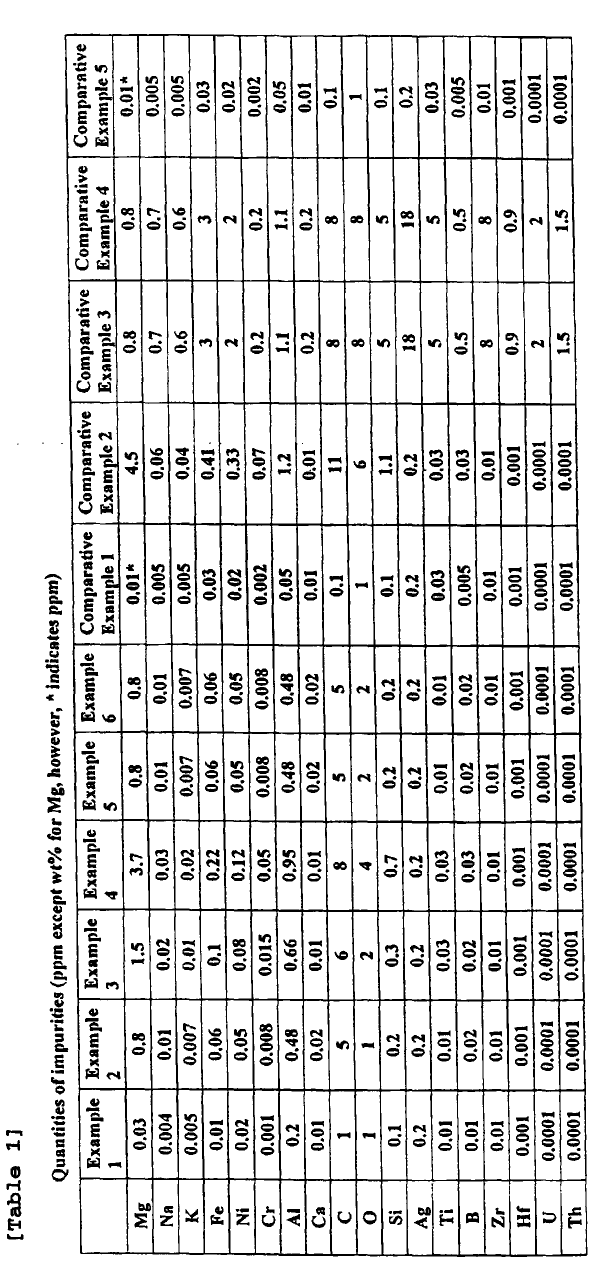

The crystal grain diameters of the targets, and the variation of the average grain diameters are shown in Table 2.

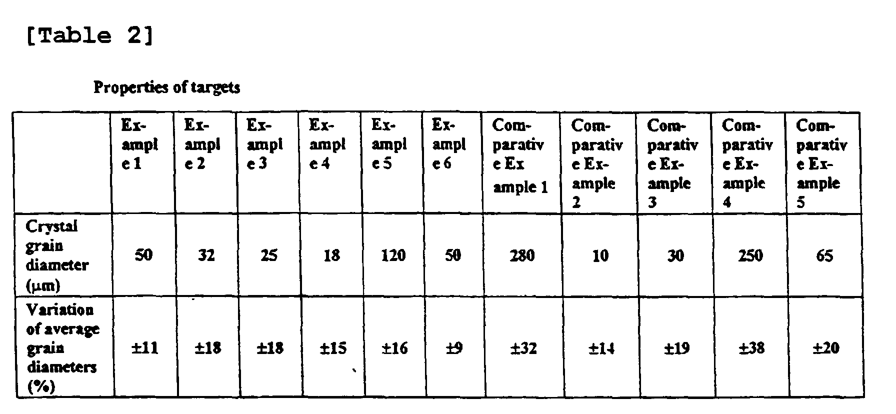

Using targets of the above-described Examples and Comparative Examples, films were formed on Si substrates each having a diameter of 8 inches under conditions of an Ar gas pressure of 5 mtorr, a sputtering power of 15 kW, and a distance between the substrate and the target of 50 mm, and the specific resistance, resistance to electro-migration, and the distribution variance of film thickness were evaluated. Incidentally, since these values vary during the initial stage of sputtering, they were evaluated after performing dummy runs until the values were stabilized. The parts eroded in the sputtering chamber was made of high-purity copper of a purity of 99.9999wt% except Example 6.

Incidentally, for evaluating oxidation resistance, a 1-µm thick film was formed on an 8-inch Si substrate under the same conditions as described above, and held for 15 minutes in the air at 200°C. The distribution of oxygen in the thickness direction of the film was investigated using an Auger analyzer.

Table 3 shows the specific resistance, variance of film thickness distribution, and the depth from the surface where oxygen is detected from the film in terms of sputtering time in Auger analysis. The table shows that when sputtering time is shorter, the depth of oxygen invasion into the film is lesser, and the higher oxygen resistance is obtained. These values were taken after performing dummy runs until the values were stabilized.

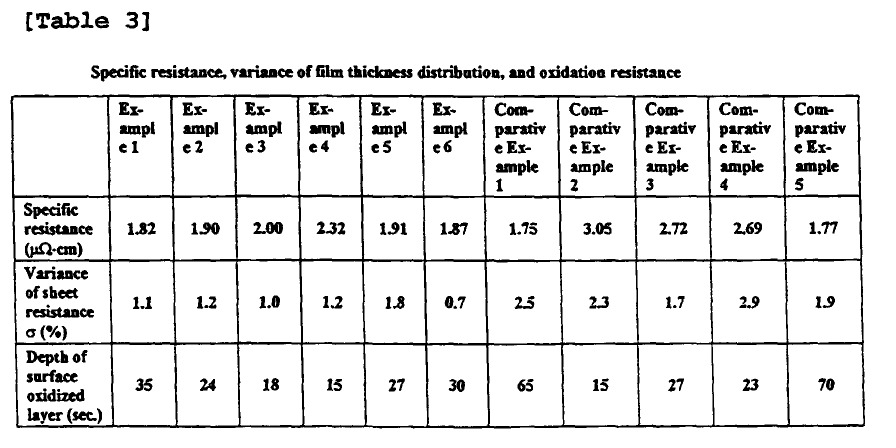

For comparing resistance to electro-migration, a film having a width of 10 µm, a thickness of 1 µm. and a length of 10 mm was formed on a wafer, heated to 400°C in argon, and the presence of voids and hillocks was checked after passing an electric current of 10 amperes for one hour. The results are shown in Table 4.

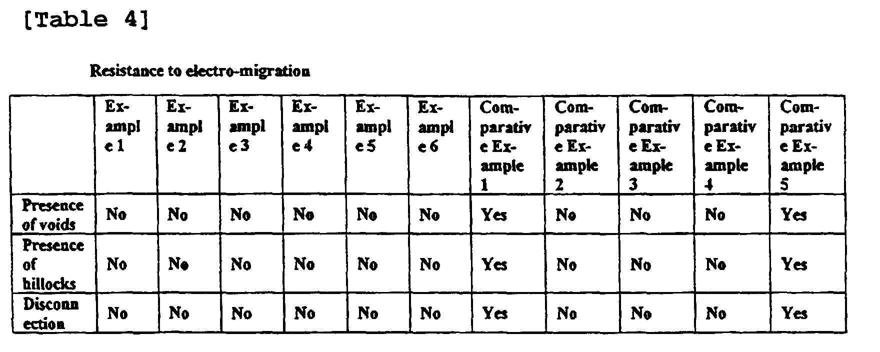

### Effect of the Invention

Using the target of the present invention having the composition range of Mg within a certain range, specified quantity of impurities in remaining copper, and crystal grain diameters and the variation thereof specified to certain values or below, a uniform film having a low wiring resistance and excellent resistance to electro-migration and oxidation can be formed uniformly on a wafer, and a reliable wiring film which can be used even for finer multi-layer wiring. In addition, by specifying the material of the parts subjected to erosion to be the same material for the target, a more uniform wiring film can be formed.

## Claims

1. A sputtering target comprising a high-purity copper alloy, wherein the content of each of Na and K is 0.5 ppm or less, the content of each of Fe, Ni, Cr, Al, and Ca is 2 ppm or less, the content of oxygen is 5 ppm or less, the content of each of U and Th is 1 ppb or less, the content of Mg is 0.02 to 4 wt%, and the content of copper is 99.99 wt% or more in the remaining portion other than the gaseous components and Mg.

2. A sputtering target comprising a high-purity copper alloy, wherein the content of each of Na and K is 0.1 ppm or less, the content of each of Fe, Ni, Cr, Al, and Ca is 1 ppm or less, the content of oxygen is 5 ppm or less, the content of each of U and Th is 1 ppb or less, the content of Mg is 0.02 to 4 wt%, and the content of copper is 99.995 wt% or more in the remaining portion other than the gaseous components and Mg.

3. The sputtering target comprising a high-purity copper alloy according to claims 1 or 2, wherein the crystal grain diameter of the target materials is 200 µm or less, and the variation of the average grain diameter throughout the target materials is ±20% or less.

4. The sputtering target comprising a high-purity copper alloy according to claims 1 or 2, wherein the crystal grain diameter of the target materials is 50 µm or less, and the variation of the average grain diameter throughout the target materials is ±20% or less.

5. A component part of thin film forming equipment used during the sputtering of the target according to any of claims 1 to 4, wherein the content of each of Na and K is 0.5 ppm or less, the content of each of Fe, Ni, Cr, Al, and Ca is 2 ppm or less, the content of oxygen is 5 ppm or less, the content of each of U and Th is 1 ppb or less, the content of Mg is 0.02 to 4wt%, and the content of copper is 99.99wt% or more in the remaining portion other than the gaseous components and Mg; and the component part is subjected to erosion during sputtering.

6. A component part of thin film forming equipment used during the sputtering of the target according to any of claims 1 to 4, wherein the content of each of Na and K is 0.1 ppm or less, the content of each of Fe, Ni, Cr, Al, and Ca is 1 ppm or less, the content of oxygen is 5 ppm or less, the content of each of U and Th is 1 ppb or less, the content of Mg is 0.02 to 4wt%, and the content of copper is 99.995wt% or more in the remaining portion other than the gaseous components and Mg; and the component part is subjected to erosion during sputtering.
